(19) Europäisches Patentamt
European Patent Office
Office européen des brevets

(11) **EP 4 481 636 A1**

(12) **EUROPEAN PATENT APPLICATION**

(43) Date of publication:
**25.12.2024 Bulletin 2024/52**

(21) Application number: **23305998.9**

(22) Date of filing: **22.06.2023**

(51) International Patent Classification (IPC):
**G06N 10/60** (2022.01)

(52) Cooperative Patent Classification (CPC):
**G06N 10/60**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **BULL SAS**
**78340 Les Clayes-Sous-Bois (FR)**

(72) Inventor: **OLIVA, Maxime**
**78340 LES CLAYES SOUS BOIS (FR)**

(74) Representative: **Plasseraud IP**
**104 Rue de Richelieu**
**CS92104**
**75080 Paris Cedex 02 (FR)**

(54) **METHOD FOR DETERMINING A LOWER BOUND OF THE FIDELITY OF AN APPROXIMATED FINAL QUANTUM STATE**

(57) Method for determining a lower bound of a fidelity of an approximated final state, comprising:
- receiving an initial state in a matrix product representation;
- receiving a quantum circuit comprising gates;
- iterating over the gates:
∘ applying a current gate to the initial state;
∘ if the current gate is a two-qubit gate, factorizing a portion of the updated state by SVD into a product of a unitary matrix, a diagonal matrix, and a unitary matrix;
• if a bond dimension of the diagonal matrix exceeds a threshold: truncating the diagonal matrix such that the bond dimension does not exceed said threshold, and determining a truncation fidelity;

∘ in a next iteration, using the updated state as the initial state;

- determining a lower bound of the fidelity of the approximated final state as a product of the truncation fidelities.

FIG. 2

## EP 4 481 636 A1

### Description

The present disclosure generally relates to the field of approximation of quantum states, and, in particular, relates to a method for determining a lower bound of the fidelity between an approximated final quantum state and an exact final quantum state.

### Summary

In many-body physics, approximated methods are employed for studying quantum systems and their temporal evolution. Such approximated methods often use tensor network-based models and thus reduce the overall complexity of exact methods based on exact quantum-mechanical models. Therefore, such approximated methods allow studying complex quantum systems and their evolution that are unreachable when using exact methods. For example, while exact methods are limited to systems of not more than around 40-45 qubits, tensor network-based methods can handle more complex systems with a much larger number of qubits.

In some methods based on tensor-network representations of quantum states in the form of matrix product states or matrix product operators, a maximum bond dimension is defined before carrying out the method. The bond dimensions of the quantum state grow during the execution of the method until they reach the maximum bond dimension, which is when truncations of the bond dimensions are initiated such that the bond dimensions do not exceed the maximum bond dimension.

However, there is no method for determining if the approximated final quantum state of a quantum system determined by such approximated methods is close to an exact final quantum state that would have been obtained with an exact method. Thus, the interest in using approximated methods is limited since it is impossible to find out whether the approximated final quantum state is a physical meaningful quantum state, i.e. if it contains meaningful physical information of the exact final quantum state that would have been obtained by the exact method.

Therefore, a need exists for providing a method that allows determining how close an approximated final quantum state is to an exact final quantum state.

### Summary

The present disclosure remedies the shortcomings of prior art.

It is disclosed a method for determining a lower bound of a fidelity between an approximated final quantum state and an exact final quantum state, the method comprising:

- receiving an initial quantum state of a plurality of qubits, the initial quantum state being in a matrix product representation comprising a product of tensors;
- receiving a quantum circuit comprising quantum gates to be applied successively to the initial quantum state, wherein each quantum gate among the quantum gates is a single-qubit quantum gate or a two-qubit quantum gate;
- iterating over the quantum gates of the quantum circuit in an intended order of application of the quantum gates to the initial quantum state, comprising:

  ○ applying a current quantum gate among the quantum gates of the quantum circuit to the initial quantum state to obtain an updated quantum state;
  ○ if the current quantum gate is a two-qubit quantum gate, factorizing a portion of the updated quantum state resulting from the application of the current quantum gate to the initial quantum state by singular value decomposition into a product of a complex unitary matrix, a diagonal matrix having a diagonal of non-negative real numbers, and an adjoint complex unitary matrix;

  • if a bond dimension of the diagonal matrix exceeds a predetermined threshold: truncating the diagonal matrix in such a way that the bond dimension after truncation is below or equal to said predetermined threshold; and determining a truncation fidelity for the truncated diagonal matrix;

  ○ in a next iteration, using the updated quantum state as the initial quantum state;

- defining an approximated final quantum state being equal to the updated quantum state of a last iteration; and
- determining a lower bound of the fidelity between the approximated final quantum state and the exact final quantum state defined as a product of the truncation fidelities.

Any type of quantum circuit can be transformed into a quantum circuit that comprises only single-qubit quantum gates and two-qubit quantum gates. Therefore, *"receiving a quantum circuit comprising quantum gates to be applied successively to the initial quantum state, wherein each quantum gate among the quantum gates is a single-qubit quantum gate or a two-qubit quantum gate"* may refer to the reception of a quantum circuit obtained by transformation of an untransformed quantum circuit comprising also quantum gates other than single-qubit quantum gates and two-qubit quantum gates.

For the case of a pure quantum state, the expression *"matrix product representation"* may mean that the pure quantum state is a matrix product state. For the case of a mixed quantum state, the expression *"matrix product representation"* may mean that the mixed quantum state is a matrix product operator or a matrix product state.

The initial quantum state, the updated quantum state, the exact final quantum state and the approximated final quantum state each describe a plurality of qubits. The bond dimension is defined between two tensors that are associated with qubits described by the quantum state. The bond dimension may be related to the maximum possible entanglement that a quantum state can encapsulate. When a two-qubit quantum gate is applied to a portion of the initial quantum state representative of said qubit pair, the bond dimension of the two tensors associated with this qubit pair may increase.

The bond dimensions between neighbouring tensors in the quantum state in matrix product representation may increase individually after the applications of quantum gates. Whenever the predetermined threshold is reached, the bond dimension between said two neighbouring tensors may be truncated. Therefore, the updated quantum state may be truncated repeatedly while applying the quantum gates.

Singular value decomposition is a method for factorizing a real or complex matrix.

The portion of the updated quantum state resulting from the application of the quantum gate to the initial quantum state may be factorized by singular value decomposition which generates a product of a complex unitary matrix, a diagonal matrix having a diagonal of non-negative real numbers, and an adjoint complex unitary matrix.

The diagonal matrix may be square-shaped. The bond dimension may correspond to the dimension of the diagonal matrix, i.e. to the number of rows/columns. Truncating the bond dimension may correspond to truncating the dimensions of the diagonal matrix for this qubit pair. Truncation of the diagonal matrix may correspond to cancelling values of the diagonal of the diagonal matrix.

The diagonal matrix may be truncated or not, depending on the respective bond dimension, and then be merged either with the complex unitary matrix or the adjoint complex unitary matrix, or with both of them.

The iteration over the quantum gates may be considered as a for-loop. The for-loop may be executed N times, where N is the number of quantum gates in the quantum circuit. In the first iteration, a first quantum gate may be applied to the initial quantum state and an updated quantum state may be obtained. In the second iteration, the updated quantum state of the first iteration is used as an initial quantum state, and a second quantum gate may be applied to the initial state. This process may be repeated until all quantum gates have been applied to the initial quantum state. In each iteration, the updated quantum state may be truncated.

The updated quantum state of the last iteration may be defined as an approximated final quantum state.

The fidelity may be a measure of the closeness of two quantum states. Here, the fidelity may measure how close an approximated final quantum state, i.e. a final quantum state obtained by approximated methods, is to an exact final quantum state, i.e. a quantum state that would have been obtained by exact methods. It may not be necessary to determine the exact final quantum state to assess how close the approximate quantum state is to the exact quantum state.

Instead, after each truncation, a truncation fidelity may be determined, reflecting the error induced by the truncation. The product of all truncation fidelities may constitute a lower bound of the fidelity between the approximated final quantum state and an exact final quantum state.

Such truncations may be particularly adapted for lowly-entangled quantum states, and therefore for large systems which generate quantum states of limited entanglement, since the error resulting from truncation may be smaller than for strongly-entangled quantum states.

The proposed method aims to respond to the drawbacks mentioned above by determining the lower bound of the fidelity between the approximated final state and an exact final quantum state. This may be done without determining the exact final quantum state. Instead, truncation fidelities may be determined after each truncation of a bond dimension, and the lower bound of the fidelity may be determined as a product of the truncation fidelities.

Therefore, the proposed method provides a measure of how close the approximated final quantum state may be to the exact final quantum state, i.e. if it contains meaningful physical information of the original exact quantum state.

Thanks to said method, complex quantum systems that may not be accessible by exact methods may now be studied fast and efficiently while at the same time a measure of the quality of the approximated method and of the approximated final quantum state may be provided. Thus, it may be possible to gain reliable information about real quantum systems that could so far not be reliably investigated and that may be difficult to be accessed by experiments.

Based on the approximated final quantum state and the lower bound, a real quantum system (such as a molecule) represented by the approximated final quantum state may be prepared and/or manipulated.

In an embodiment, truncating the diagonal matrix may comprise canceling one or more diagonal elements of the diagonal matrix.

As a result, one or more rows and columns of the truncated diagonal matrix only comprise zeros and may therefore be canceled. Thus, the bond dimension and the complexity of the determined quantum state may be reduced.

In an embodiment, said one or more diagonal elements may be canceled in increasing order, starting from an element with a smallest value.

In the diagonal matrix generated by singular value decomposition, the diagonal elements are arranged in decreasing order, starting from the top left to the bottom right of the diagonal matrix. Thus, the diagonal elements may be canceled starting from the bottom right to the top left.

In an embodiment, if the initial quantum state and the approximated final quantum state are pure quantum states, the truncation fidelity may be defined as:

$$f_j = \frac{\sum_i \left( \Lambda_{ii} \Lambda'_{ii} \right)^2}{\sum_i \Lambda_{ii}^2 \sum_i \Lambda'_{ii}^2}$$

where $\Lambda_{ii}$ may be elements of the diagonal matrix before truncation and $\Lambda'_{ii}$ may be elements of the diagonal matrix after truncation.

In an embodiment, if the initial quantum state and the approximated final quantum state are mixed quantum states, the truncation fidelity may be defined as:

$$f_j = \frac{\sum_i \Lambda_{ii} \Lambda'_{ii}}{\sqrt{\sum_i \Lambda_{ii}^2 \sum_i \Lambda'_{ii}^2}}$$

where $\Lambda_{ii}$ may be elements of the diagonal matrix before truncation and $\Lambda'_{ii}$ may be elements of the diagonal matrix after truncation.

Thus, the truncation fidelities and thus the lower bound of the fidelity may be determined based on the diagonal matrices before and after truncation, which may be considerably faster and more efficient than determining the fidelity via the exact final quantum state.

In an embodiment, having defined the approximated final quantum state and having determined the lower bound of the fidelity, the method may comprise:

- outputting the approximated final quantum state and the lower bound of the fidelity.

The approximated final quantum state and the lower bound of the fidelity may be displayed on a computer screen and serve for further analysis. For example, if a quantum system such as a molecule or an atom is studied, further analysis may comprise the determination of energy states of the quantum system, based on the approximated final quantum state.

In addition, based on the output approximated final quantum state and the output lower bound, a real quantum system represented by the approximated final quantum state may be prepared and/or manipulated.

In an embodiment, having defined the approximated final quantum state and having determined the lower bound of the fidelity, the method may comprise:

- deciding based on the lower bound of the fidelity and on a predetermined criterion whether the approximated final quantum state may be a realistic approximation of the exact final quantum state.

The predetermined criterion may comprise determining whether the determined lower bound is below or above a predefined value. The predefined value may depend on the type of quantum system (e.g. an atom, a molecule) and on the type of quantum circuit that is studied, for example on the number of quantum gates of the quantum circuit.

Based on the predetermined criterion, it may be decided whether the approximated final quantum state is a realistic approximation of the exact final quantum state, i.e. if it contains meaningful physical information of the original exact quantum state.

Based on said predetermined criterion, it may be decided whether the method should be carried out again with different amounts of truncation. For example, if the determined lower bound is too low, it may be decided that the approximated final quantum state is not a realistic representation of the approximated final quantum state, and that the method should be reperformed with higher bond dimension, i.e. less truncation.

Based on said criterion, it may be decided whether the approximated final state should be analyzed further, in order to extract properties about the investigated quantum system.

Based on the criterion, it may be decided whether a real quantum system represented by the approximated final quantum state may be prepared and/or manipulated.

Another aspect of the disclosure may be related to a non-transitory computer readable storage medium, having stored thereon a computer program comprising program instructions, the computer program being loadable into a data-processing unit and adapted to cause the data-processing unit to carry out a method according to any of the embodiments described above.

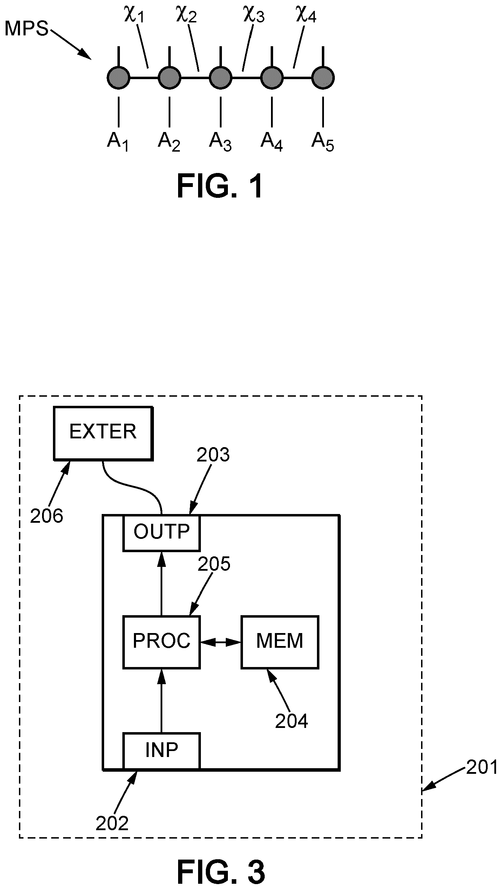

Figure 3 shows such a non-transitory computer readable storage medium.

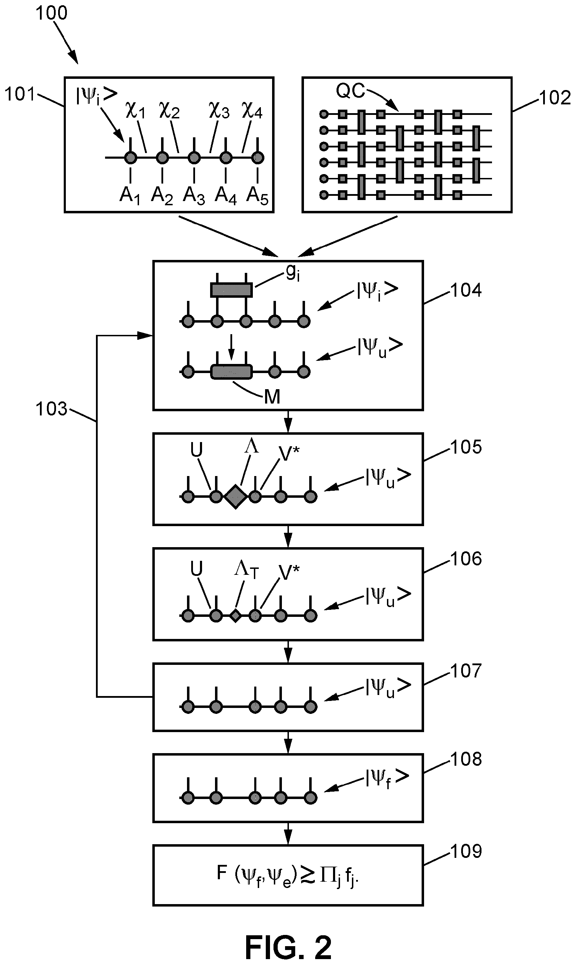

Figure 2 can form the flowchart for the general algorithm of such a computer program.

## Brief Description of Drawings

Other features, details and advantages will be shown in the following detailed description and on the figures, on which:

**Fig. 1**
[Fig. 1] is a schematic representation of an example of a matrix product state used in the method of the present disclosure.

**Fig. 2**
[Fig. 2] is a view of a flowchart of an example of a method for determining a lower bound of a fidelity between an approximated final quantum state and an exact final quantum state.

**Fig. 3**
[Fig. 3] shows a non-transitory computer readable storage medium configured to implement a method for determining a lower bound of a fidelity between an approximated final quantum state and an exact final quantum state.

## Description of Embodiments

In the following, a method for determining a lower bound of a fidelity between an approximated final quantum state and an exact final quantum state will be described. The method may be implemented according to several embodiments.

When modeling a system of qubits, the quantum state of the qubits may be described either as a pure quantum state or as a mixed quantum state.

A pure quantum state describing a system of N qubits can be represented by a vector:

$$|\psi> = \sum_{\sigma_1 \dots \sigma_N} C_{\sigma_1 \dots \sigma_N} |\sigma_1> \otimes \dots \otimes |\sigma_N>$$

Here, the $\{|\sigma_i>\}$ form an orthonormal basis, and $C_{\sigma_1 \dots \sigma_N}$ is a complex valued tensor containing $2^N$ complex elements.

A mixed quantum state is a statistical ensemble of pure quantum states. A mixed quantum state describing a system of N qubits can be represented as:

$$\rho = \sum_{\sigma_1 \dots \sigma_N} C_{\sigma_1 \sigma'_1 \dots \sigma_N \sigma'_N} |\sigma_1> < \sigma'_1| \otimes \dots \otimes |\sigma_N> < \sigma'_N|$$

Here, the $\{|\sigma_i> < \sigma'_i|\}$ form an orthonormal basis, and $C_{\sigma_1 \sigma'_1 \dots \sigma_N \sigma'_N}$ is a complex valued tensor.

Both pure and mixed quantum states can be written in a matrix product representation.

As demonstrated by Guifre Vidal, "Efficient classical simulation of slightly entangled quantum computations", Phys. Rev. Lett. 91, 147902, 2003, a pure quantum state $|\psi>$ as described above can be written as a matrix product state:

$$|\psi> = \sum_{\sigma_1 \dots \sigma_N ; \chi_1 \dots \chi_{N-1}} A_{1,\chi_1}^{[1]\sigma_1} A_{\chi_1,\chi_2}^{[2]\sigma_2} \dots A_{\chi_{N-1},1}^{[N]\sigma_N} |\sigma_1> \otimes \dots \otimes |\sigma_N>$$

where $A_{1,\chi_1}^{[1]\sigma_1} \cdots A_{\chi_{N-1},1}^{[N]\sigma_N}$ are complex valued tensors of dimension 3, separated by bond dimension $\chi_1, \ldots \chi_{N-1}$, respectively. The coupling between two tensors representing a pair of qubits may be described by a respective bond dimension $\chi_1, \ldots \chi_{N-1}$.

The more the bond dimensions increase within the quantum state in matrix product representation, the more the quantum state will be able to represent entangled quantum states.

As it is know from Kyungjoo Noh et al., "Efficient classical simulation of noisy random quantum circuits in one dimension", Quantum 4, 318, 2020, a mixed quantum state $p$ written as a matrix product state in vectorized representation has the following form:

$$|\rho> = \sum_{\chi_1 \cdots \chi_{N-1}} A_{1,\chi_1}^{[1]\sigma_1} \ldots A_{\chi_T,\chi_{T+1}}^{[T]\sigma_T} A_{\chi_{T+1},\chi_{T+2}}^{[T+1]\sigma_{T+1}} \ldots A_{\chi_{N-1},1}^{[N]\sigma_N} |\Sigma_1 > \otimes \ldots \otimes |\Sigma_N >$$

Here, $\Sigma_i = \sigma_i \times \sigma'_i$ and $|\Sigma_i> = |\sigma_i> |\sigma_i>$, with i = 1...N.

An example of a schematic representation of a matrix product state MPS is shown in figure 1. In this example, the matrix product state MPS describes the quantum state of five qubits $\sigma_1, \sigma_2, \sigma_3, \sigma_4, \sigma_5$, wherein the matrix product state MPS can be represented as a product of the tensors $A_{1,\chi_1}^{[1]\sigma_1}, A_{2,\chi_2}^{[2]\sigma_2}, A_{3,\chi_3}^{[3]\sigma_3}, A_{4,\chi_4}^{[4]\sigma_4}, A_{5,\chi_5}^{[5]\sigma_5}$, referred to as $A_1, A_2, A_3, A_4, A_5$ for simplicity.

Each of the five circles in figure 1 are representative of the tensors $A_{\chi_k,\chi_{k+1}}^{[k]\sigma_k}$ associated with the qubits $\sigma_k$. $\chi_k$ and $\chi_{k+1}$ are the bond dimensions between the tensor on the left and the tensor on the right of $A^{[k]}$, respectively.

An initial quantum state in the form of a matrix product state MPS will be transformed by applying quantum gates to it. When applying the quantum gates to the initial quantum state, each bond dimension $\chi_1, \chi_2, \chi_3, \chi_4$ may grow exponentially with the number N of qubits $\sigma_1, \sigma_2, \sigma_3, \sigma_4, \sigma_5$: $O(e^N)$. Therefore, the complexity of the term $A_{1,\chi_1}^{[1]\sigma_1} A_{1,\chi_1, \chi_2}^{[2]\sigma_2} \ldots A_{\chi_{N-1},1}^{[N]\sigma_N}$ and thus the complexity of the corresponding matrix product state MPS grows exponentially as well.

In order to reduce the complexity of such methods, the updated quantum state resulting from the application of a quantum gate to the initial quantum state may be truncated.

By truncating any $\chi_i$ of $\chi_1, \ldots \chi_{N-1}$ such that $\chi_i$ does not exceed a predetermined threshold $\chi_{max}$, each of the $\chi_i$-values will be equal to or smaller than $\chi_{max}$, and thus the complexity of the method may be limited to $O(N_{\chi max}^2)$ for pure states and to $O(N^2_{\chi max}^3)$ for mixed states.

It is then possible to determine how close the approximated final quantum state obtained from such an approximated method is to an exact final quantum state that would have been obtained from an exact method without any truncation.

Figure 2 shows a flow chart of a method 100 for determining a lower bound of a fidelity of an approximated final quantum state $|\psi_i>$ obtained by an approximated method with respect to an exact final quantum state that would have been obtained from an exact method. The lower bound of the fidelity is determined without determining the exact final quantum state.

Here, the case of a pure quantum state is considered by way of example.

At the beginning of the method 100, an initial quantum state $|\psi_i>$ describing a plurality of qubits $\sigma_1, \sigma_2, \sigma_3, \sigma_4, \sigma_5$ is received 101. The initial quantum state $|\psi_i>$ is a matrix product state MPS.

Furthermore, a quantum circuit QC comprising a plurality of quantum gates to be applied to the initial quantum state $|\psi_i>$ is received 102. For the case of pure states (i.e. noiseless circuits), if all quantum gates of the quantum circuit QC were merged together, the quantum circuit QC could be represented as a unitary matrix u and the exact final quantum state $|\psi_e>$ could be determined by applying the unitary matrix u to the initial quantum state $|\psi_i>$: $|\psi_e> = u|\psi_i>$. However, in practice the exact final quantum state is generally not determined since its determination may be too complex if the size of the studied system is too large.

It is then iterated 103 over the quantum gates, in an intended order of application of the quantum gates to the initial quantum state $|\psi_i>$. In each repetition of the iteration 103, a current quantum gate $g_i$ is applied 104 to the initial quantum state $|\psi_i>$. Thus, the quantum gates are applied successively to the initial quantum state $|\psi_i>$.

Single-qubit gates do not increase the bond dimension. However, two-qubit quantum gates increase the bond dimensions between the tensors to which the quantum gate is applied.

Now, one iteration is considered, in which a current quantum gate $g_i$ in the form of a two-qubit quantum gate is applied to the initial quantum state $|\psi_i>$.

Here, the current quantum gate $g_i$ acts on the two qubits $\sigma_2, \sigma_3$.

A portion M of the updated quantum state $|\psi_u>$ resulting from the application of the current quantum gate $g_i$ to the initial quantum state $|\psi_i>$ may be factorized 105 by singular value decomposition into

$$M = U\Lambda V^*$$

where U is a complex unitary matrix, $\Lambda$ a diagonal matrix having a diagonal of non-negative real numbers, and $V^*$ an adjoint complex unitary matrix.

It may be verified if the bond dimension $\chi_2$ between two neigbouring tensors associated with qubits $\sigma_2$ and $\sigma_3$ on which the current quantum gate $g_i$ acts exceeds a predetermined threshold.

The bond dimension $\chi_2$ corresponds to the dimension of the diagonal matrix $\Lambda$. If the bond dimension $\chi_2$ exceeds a predetermined threshold, the diagonal matrix $\Lambda$ is truncated 106, meaning that one or more values from the diagonal of the diagonal matrix $\Lambda$ are canceled, i.e. they are replaced by zero.

The diagonal elements of the diagonal matrix $\Lambda$ are arranged in decreasing order, wherein the element with lowest value is on the lower right of the diagonal. The truncation is done starting from the lowest value and in increasing order. Due to the cancellation of elements of the diagonal matrix $\Lambda$, rows and columns containing only zeros occur. All rows and columns containing zeros may be canceled from the diagonal matrix $\Lambda$. Thus, the bond dimension $\chi_2$ is reduced.

Truncation stops when the bond dimension $\chi_2$ is below said threshold.

The diagonal matrix $\Lambda_T$ after truncation can then be merged 107 either with the complex unitary U matrix or the adjoint complex unitary matrix $V^*$.

The iteration over the quantum gates can be considered as a for-loop. The for-loop is executed N times, where N is the number of quantum gates in the quantum circuit QC. In the first iteration, a current quantum gate $g_i$ is applied to the initial quantum state $|\psi_i\rangle$ and an updated quantum state $|\psi_u\rangle$ is obtained. If the quantum gate $g_i$ is a two-qubit quantum gate, the portion M of the updated quantum state $|\psi_u\rangle$ resulting from the application of the first quantum gate to the initial quantum state $|\psi_i\rangle$ may be factorized by singular value decomposition. The resulting diagonal matrix $\Lambda$ may then be truncated in dependence of its bond dimension.

In the second iteration, the updated quantum state $|\psi_u\rangle$ of the first iteration is used as an initial quantum state $|\psi_i\rangle$, and a next current quantum gate $g_i$ is applied to the initial quantum state $|\psi_i\rangle$. This process is iterated until all quantum gate have been applied to the initial quantum state $|\psi_i\rangle$.

The updated quantum state $|\psi_u\rangle$ of the last operation is defined 108 as an approximated final quantum state $|\psi_f\rangle$.

For each truncated diagonal matrix $\Lambda_T$, a truncation fidelity may be determined. The truncation fidelity is representative of the error induced due to the truncation. The truncation fidelity may be determined based on the diagonal matrix $\Lambda$ before truncation and on the diagonal matrix $\Lambda_T$ after truncation, as will be explained later.

In dependence on the total amount of truncation, the approximated final quantum state $|\psi_f\rangle$ may be reliable, i.e. it may be close to an exact final quantum state that would have been obtained from an exact method, that is without any truncation. The quality and the reliability of the approximated final quantum state may be quantified by the fidelity.

For a pure quantum state, the fidelity may be determined as:

$$F(\psi_f, \psi_e) = |<\psi_f|\psi_e>|^2$$

where $F(\psi_f, \psi_e)$ is the fidelity, $\psi_f$ is the approximated final quantum state and $\psi_e$ is the exact final quantum state.

For a mixed quantum state, the fidelity may be determined as:

$$F(\rho_f, \rho_e) = Tr(\sqrt{\sqrt{\rho_f}\rho_e\sqrt{\rho_f}})^2$$

wherei $F(\rho_f, \rho_e)$ is the fidelity, $\rho_e$ is the exact final quantum state and $\rho_f$ is the approximated final quantum state.

This expression is known from Richard Jozsa, "Fidelity for Mixed Quantum States", Journal of Modern Optics, Volume 41, Issue 12, 1994.

However, approximations of matrix product operators can lead to the loss of semi-definite properties of the density matrix, which is a necessary condition for determining the matrix square roots.

To solve this issue, an alternative fidelity definition is chosen for a mixed quantum state:

$$F(\rho_f, \rho_e) = \frac{|Tr(\rho_f\rho_e)|}{\sqrt{Tr(\rho_f^2)Tr(\rho_e^2)}}$$

This expression is known from Xiaoguang Wang et al., "An alternative quantum fidelity for mixed states of qudits", arXiv:0807.1781, 2008.

However, as mentioned, the exact final quantum states $\psi_e$ and $\rho_e$ are generally not known since there determination is too complex. Nevertheless, it is possible to determine a lower bound of the fidelity.

Therefore, random quantum circuits are considered. Random quantum circuits are a class of quantum circuit where each quantum gate is chosen randomly. Random quantum circuits generate a maximum amount of entanglement in the fewest number of quantum gates.

When applying a so-called Haar-random circuits to an initial quantum state $|\psi_i\rangle$, a Haar-random state with almost maximum entanglement entropy is generated (Page's theorem). This is known from Don N. Page, "Average Entropy of a Subsystem", Phys. Rev. Lett. 71, 1291, 1993; S. K. Foong, "Proof of Page's conjecture on the average entropy of a subsystem", Phys. Rev. Lett. 72, 1148, 1994; Jorge Sánchez-Ruiz, "Simple proof of Page's conjecture on the average entropy of a subsystem", Phys. Rev. E 52, 5653, 1995; and Siddhartha Sen, "Average Entropy of a Quantum Subsystem", Phys. Rev. Lett. 77, 1, 1996.

As it is known from Yiqing Zhou, "What limits the simulation of quantum computers?", arXiv:2002.07730, 2020, for a random quantum circuit, the fidelity of the approximated final quantum state $|\psi_f\rangle$ obtained after an approximated simulation of a random quantum circuit is the product of the truncation fidelities $f_j$ obtained after each truncation throughout the simulation. Therefore, for a simulation with a random quantum circuit, the fidelity $F_{random}$ is determined as:

$$F_{random} \approx \prod_j f_j$$

When the matrix product state MPS is in left canonical form on the left of the truncation site, and in right canonical form on the right canonical form on its right, the following relation holds for the quantum state before truncation $|\psi_{BT}\rangle$, the quantum state after truncation $|\psi_{AT}\rangle$, the elements $\Lambda_{ii}$ of the diagonal matrix $\Lambda$ before truncation and the elements $\Lambda'_{ii}$ of the diagonal matrix $\Lambda_T$ after truncation:

$$\langle \psi_{BT}|\psi_{AT}\rangle = \sum_i \Lambda_{ii}\Lambda'_{ii}$$

Since the singular values of $\Lambda_{ii}$ are always positive, the truncation fidelity $f_j$ for a truncation site j of a pure quantum state can be defined as:

$$f_j(|\psi_{BT}\rangle, |\psi_{AT}\rangle) = \frac{\sum_i (\Lambda_{ii}\Lambda'_{ii})^2}{\sum_i \Lambda_{ii}^2 \sum_i \Lambda'^2_{ii}}$$

For a mixed quantum state, the truncation fidelity $f_j$ is determined as:

$$f_j(\rho_{BT}, \rho_{AT}) = \frac{\sum_i \Lambda_{ii}\Lambda'_{ii}}{\sqrt{\sum_i \Lambda_{ii}^2 \sum_i \Lambda'^2_{ii}}}$$

Since random quantum circuits lead to the maximum amount of entanglement, they also lead to the maximum amount of error committed when truncating a quantum state. Thus, the fidelity $F_{random}$ being a product of the truncation fidelities $\Pi_j f_j$ constitutes a lower bound for the fidelity for any approximated final quantum state $|\psi_f\rangle$ obtained by applying any kind of quantum circuit to an initial quantum state $|\psi_i\rangle$.

Noise is an important parameter in quantum circuits. Noise leads to decreased entanglement entropy. Therefore, methods that take into account noise lead to quantum states with decreased entanglement. Therefore, the error resulting from truncation is lower than the error from truncation a quantum state without noise, and the fidelity is thus higher.

The threshold $F_{random} \approx \Pi_j f_j$ is a lower bound for an approximated final quantum state $|\psi_f\rangle$ resulting from the application of any noisy or noiseless quantum circuit.

Having determined the truncation fidelity for each truncated diagonal matrix $\Lambda_T$, a lower bound of the fidelity between the approximated final quantum state and the exact final quantum state can be determined 109. For any quantum circuit applied to an initial quantum state the following relation holds: $F(\psi_f, \psi_e) \geq \Pi_j f_j$.

In dependence on the specifics of the quantum circuit that is considered, the fidelity may be close to the determined lower bound, which may be the case for example if the considered quantum circuit is close to a random quantum circuit. However, if the considered quantum circuit creates little entanglement, the fidelity may be considerably larger than the lower bound.

The blocks 101, 102, 103, 104, 105, 106, 107, 108, 109 of the method 100 are not necessarily executed in the indicated order. For example, the reception 101 of the initial quantum state $|\psi_i\rangle$ may occur before, after or at the same time as the reception 102 quantum circuit QC.

The approximated final quantum state $|\psi_f\rangle$ and the lower bound of the fidelity may be output, for example on a computer screen. The lower bound on the approximated final quantum state $|\psi_f\rangle$ may serve for further analysis. Based on the lower bound of the fidelity and on a predetermined criterion it may be decided whether the approximated final quantum state $|\psi_f\rangle$ is a realistic approximation of the exact final quantum state.

For example, if a quantum system such as a molecule or an atom is studied, further analysis may comprise the determination of energy states of the quantum system, based on the approximated final quantum state $|\psi_f\rangle$.

The predetermined criterion may comprise determining whether the determined lower bound is below or above a predefined value. The predefined value may depend on the type of quantum system (e.g. an atom, a molecule) and on the type of quantum circuit QC that is studied, for example on the number of quantum gates of the quantum circuit QC.

Based on the predetermined criterion, it may be decided whether the approximated final quantum state $|\psi_f\rangle$ is a realistic approximation of the exact final quantum state $|\psi_e\rangle$, if it contains meaningful physical information of the original exact quantum state.

Based on said predetermined criterion, it may be decided whether the method 100 should be carried out again with different amounts of truncation. For example, if the lower bound is too low, it may be decided that the approximated final quantum state $|\psi_f\rangle$ is not a realistic representation of the approximated final quantum state $|\psi_f\rangle$, and that the method 100 should be reperformed with less truncation.

Based on said criterion, it may be decided whether the approximated final quantum state should be analyzed further, in order to extract properties about the investigated quantum system.

The method described above has numerous applications, for example in quantum computing.

In one particular example not shown in the figures, a fermionic problem may be defined. This means that the expression for a Hamiltonian to be solved is determined. Based on the problem to solve, we define a variational quantum circuit (also called an ansatz). The Hamiltonian is then minimized so as to find its ground state (e.g. the minimum energy level of the quantum system under investigation). The problem is solved via a variational quantum eigensolver (VQE), which requires many executions of the quantum circuit, i.e. many applications of the quantum circuit to an initial quantum state, which is done using the method of figure 2. At the end of this iterative process, the ground state energy of the quantum system is determined.

This ground state energy can be used further in multiple ways:

- thermodynamics stability of reactions can be probed by determining the energy difference between reactants and products;

- several properties of the quantum system can be derived from the ground state energy value, such as dipoles, polarizabilities, or interaction forces;

- excitation energies are defined relatively to the ground state. The ground state is required to study any kind of excitation energy of any atom/molecule.

Based on the determined ground state energy and/or physical properties derived from the ground state energy, a real quantum system (such as a molecule) may be prepared and/or manipulated.

Figure 3 shows a control unit 201 configured to implement the method 100 described in relation to figure 2.

The control unit 201 may comprise a memory 204 for storing instructions for implementation of at least part of the method, the data received, and temporary data for performing the various blocks and operations of the method.

The control unit 201 further comprises a control circuit 205. This control circuit can be, for example: a processor capable of interpreting instructions in the form of a computer program, or an electronic card whose blocks and operations of the method of disclosure are described in silicon, or a programmable electronic chip such as an FPGA for "Field-Programmable Gate Array", as a SOC for "System On Chip" or as an ASIC for "Application Specific Integrated Circuit".

SOCs or systems-on-chips are embedded systems that integrate all the components of an electronic system into a single chip. An ASIC is a dedicated electronic circuit that brings together custom features for a given application. The programmable logic circuits of the FPGA type are reconfigurable electronic circuits by the user of the control unit 201.

The control unit 201 comprises an input interface 202 for receiving messages or instructions, and an output interface 203 for communication with the electronic entities of the system which implements the method according to the present disclosure.

Depending on the embodiment, the control unit 201 may be a computer, a computer network, an electronic component, or another device comprising a processor 205 operatively coupled to a memory 204, and, depending on the mode of operation, selected embodiment, a data storage unit, and other associated hardware elements such as a network interface and a media reader for reading a removable storage medium 206 and writing on such a medium. The removable storage medium may be, for example, a flash disk, a USB stick, etc.

According to the embodiment, the memory 204, the data storage unit or the removable storage medium contains instructions which, when executed by the processor 205, cause this control unit 201 to performing or controlling the input interface 202, output interface 203, data storage in the memory 204 and / or data processing and method implementation examples described herein.

In addition, the instructions can be implemented in software form, in which case it takes the form of a program executable by a processor 205, or in hardware form, or "hardware", as an integrated circuit specific application ASIC, a SOC on a microchip, or in the form of a combination of hardware and software elements, for example a software program intended to be loaded and executed on an electronic component described above such as FPGA processor.

The control unit 201 can also use hybrid architectures, for example architectures based on a CPU + FPGA, or an MPPA for "Multi-Purpose Processor Array".

**Claims**

1. A method (100) for determining a lower bound of a fidelity between an approximated final quantum state ($|\psi_f\rangle$) and an exact final quantum state, the method comprising:

   - receiving (101) an initial quantum state ($|\psi_i\rangle$) of a plurality of qubits, the initial quantum state being in a matrix product representation comprising a product of tensors ($A_1,A_2,A_3,A_4,A_5$);
   - receiving (102) a quantum circuit (QC) comprising quantum gates to be applied successively to the initial quantum state ($|\psi_i\rangle$), wherein each quantum gate among the quantum gates is a single-qubit quantum gate or a two-qubit quantum gate;
   - iterating (103) over the quantum gates of the quantum circuit (QC) in an intended order of application of the quantum gates to the initial quantum state ($|\psi_i\rangle$), comprising:

     ◦ applying (104) a current quantum gate ($g_i$) among the quantum gates of the quantum circuit (QC) to the initial quantum state ($|\psi_i\rangle$) to obtain an updated quantum state ($|\psi_u\rangle$);
     ◦ if the current quantum gate ($g_i$) is a two-qubit quantum gate, factorizing (105) a portion (M) of the updated quantum state ($|\psi_u\rangle$) resulting from the application of the current quantum gate ($g_i$) to the initial quantum state ($|\psi_i\rangle$) by singular value decomposition into a product of a complex unitary matrix (U), a diagonal matrix ($\Lambda$) having a diagonal of non-negative real numbers, and an adjoint complex unitary matrix (V*);

       • if a bond dimension ($\chi_1,\chi_2,\chi_3,\chi_4$) of the diagonal matrix ($\Lambda$) exceeds a predetermined threshold: truncating (106) the diagonal matrix ($\Lambda$) in such a way that the bond dimension after truncation is below or equal to said predetermined threshold; and determining a truncation fidelity for the truncated diagonal matrix ($\Lambda_T$);

     ◦ in a next iteration, using the updated quantum state ($|\psi_u\rangle$) as the initial quantum state ($|\psi_i\rangle$);

   - defining (108) an approximated final quantum state ($|\psi_f\rangle$) being equal to the updated quantum state ($|\psi_u\rangle$) of a last iteration; and
   - determining (109) a lower bound of the fidelity between the approximated final quantum state ($|\psi_f\rangle$) and the exact final quantum state defined as a product of the truncation fidelities.

2. The method according to claim 1, wherein truncating the diagonal matrix ($\Lambda$ comprises canceling one or more diagonal elements of the diagonal matrix ($\Lambda$).

3. The method according to claim 2, wherein said one or more diagonal elements are canceled in increasing order, starting from an element with a smallest value.

4. The method according to any of the previous claims, wherein, if the initial quantum state ($|\psi_i\rangle$) and the approximated final quantum state ($|\psi_f\rangle$) are pure quantum states, the truncation fidelity is defined as:

$$f_j = \frac{\sum_i (\Lambda_{ii}\Lambda'_{ii})^2}{\sum_i \Lambda_{ii}{}^2 \sum_i \Lambda'_{ii}{}^2}$$

where $\Lambda_{ii}$ are elements of the diagonal matrix ($\Lambda$) before truncation and $\Lambda'_{ii}$ are elements of the diagonal matrix ($\Lambda_T$) after truncation.

5. The method according to any claims 1 - 3, wherein, if the initial quantum state and the approximated final quantum state are mixed quantum states, the truncation fidelity is defined as:

$$f_j = \frac{\sum_i \Lambda_{ii}\Lambda'_{ii}}{\sqrt{\sum_i \Lambda_{ii}{}^2 \sum_i \Lambda'_{ii}{}^2}}$$

where $\Lambda_{ii}$ are elements of the diagonal matrix ($\Lambda$) before truncation and $\Lambda'_{ii}$ are elements of the diagonal matrix ($\Lambda_T$) after truncation.

6. The method according to any of the previous claims, further comprising, having defined the approximated final quantum state ($|\psi_f\rangle$) and having determined the lower bound of the fidelity:

   - outputting the approximated final quantum state ($|\psi_f\rangle$) and the lower bound of the fidelity.

7. The method according to any of the previous claims, further comprising, having defined the approximated final quantum state ($|\psi_f\rangle$) and having determined the lower bound of the fidelity:

   - deciding based on the lower bound of the fidelity and on a predetermined criterion whether the approximated final quantum state ($|\psi_f\rangle$) is a realistic approximation of the exact final quantum state.

8. A non-transitory computer readable storage medium (201), having stored thereon a computer program comprising program instructions, the computer program being loadable into a data-processing unit and adapted to cause the data-processing unit to carry out a method of any of the previous claims.

MPS

$\chi_1$  $\chi_2$  $\chi_3$  $\chi_4$

$A_1$  $A_2$  $A_3$  $A_4$  $A_5$

## FIG. 1

EXTER

206

203

OUTP

205

PROC ◄► MEM

204

INP

202

201

## FIG. 3

**FIG. 2**

Europäisches
Patentamt

European
Patent Office

Office européen
des brevets

# EUROPEAN SEARCH REPORT

**Application Number**

EP 23 30 5998

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | THOMAS AYRAL ET AL: "A density-matrix renormalisation group algorithm for simulating quantum circuits with a finite fidelity", ARXIV.ORG, CORNELL UNIVERSITY LIBRARY, 201 OLIN LIBRARY CORNELL UNIVERSITY ITHACA, NY 14853, 12 July 2022 (2022-07-12), XP091269335, * page 2 – page 18 * | 1-8 | INV. G06N10/60 |
| A | MARKUS HAURU ET AL: "Uhlmann fidelities from tensor networks", ARXIV.ORG, CORNELL UNIVERSITY LIBRARY, 201 OLIN LIBRARY CORNELL UNIVERSITY ITHACA, NY 14853, 4 July 2018 (2018-07-04), XP081244002, * page 1 – page 1 * | 1-8 | |

TECHNICAL FIELDS SEARCHED (IPC)

G06N

The present search report has been drawn up for all claims

| Place of search | Date of completion of the search | Examiner |
|---|---|---|
| The Hague | 4 December 2023 | Falco, Gabriele |

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **GUIFRE VIDAL**. Efficient classical simulation of slightly entangled quantum computations. *Phys. Rev. Lett.*, 2003, vol. 91, 147902
- **KYUNGJOO NOH et al.** Efficient classical simulation of noisy random quantum circuits in one dimension. *Quantum*, 2020, vol. 4, 318
- **RICHARD JOZSA**. Fidelity for Mixed Quantum States. *Journal of Modern Optics*, 1994, vol. 41 (12)
- **XIAOGUANG WANG et al.** An alternative quantum fidelity for mixed states of qudits. *arXiv:0807.1781*, 2008
- **DON N. PAGE**. Average Entropy of a Subsystem. *Phys. Rev. Lett.*, 1993, vol. 71, 1291
- **S. K. FOONG**. Proof of Page's conjecture on the average entropy of a subsystem. *Phys. Rev. Lett.*, 1994, vol. 72, 1148
- **JORGE SÁNCHEZ-RUIZ**. Simple proof of Page's conjecture on the average entropy of a subsystem. *Phys. Rev.*, 1995, vol. E 52, 5653
- **SIDDHARTHA SEN**. Average Entropy of a Quantum Subsystem. *Phys. Rev. Lett.*, 1996, vol. 77, 1
- **YIQING ZHOU**. What limits the simulation of quantum computers?. *arXiv:2002.07730*, 2020